# EUROPÄISCHE PATENTANMELDUNG

(11) **EP 2 230 687 A2**
(43) Veröffentlichungstag der Anmeldung: **22.09.2010**
(21) Anmeldenummer: 10156602.4
(22) Anmeldetag: 16.03.2010
(51) Int. Cl.: H01L 23/498

(54) **Schaltungsanordnung, Verfahren zum elektrischen und/oder mechanischen Verbinden und Vorrichtung zum Aufbringen von Verbindungselementen**

(30) Priorität: 18.03.2009 DE 102009013826
(71) Anmelder: Michalk, Manfred, 99092 Erfurt (DE)
(72) Erfinder: Michalk, Manfred, 99092 Erfurt (DE)
(74) Vertreter: Liedtke, Markus

(57) **Zusammenfassung**

Die Erfindung betrifft eine Schaltungsanordnung, umfassend zumindest zwei Verbindungspartner (10.1, 10.2, 10.3), welche über Verbindungsflächen (7.1, 7.2, 7.3) elektrisch und/oder mechanisch miteinander verbunden sind, wobei die Verbindungspartner (10.1, 10.2, 10.3) Leiterbahnen, elektrisch leitfähige Fasermaterialien und/oder elektronische Bauelemente sind. Erfindungsgemäß ist zwischen den Verbindungsflächen (7.1, 7.2, 7.3) zumindest ein Verbindungselement (1) angeordnet, welches mit zumindest einer Verbindungsfläche (7.1, 7.2, 7.3) formschlüssig und/oder stoffschlüssig verbunden ist.

Des Weiteren betrifft die Erfindung ein Verfahren zum elektrischen und/oder mechanischen Verbinden von Vcrbindungspartncrn (10.1, 10.2, 10.3) einer Schaltungsanordnung und eine Vorrichtung (16) zum Aufbringen von Verbindungselementen (1) auf eine Verbindungsfläche (7.1, 7.2, 7.3).

## Beschreibung

Die Erfindung betrifft eine Schaltungsanordnung nach den Merkmalen des Oberbegriffs des Anspruchs 1, ein Verfahren zum elektrischen und mechanischen Verbinden von Verbindungspartnern einer Schaltungsanordnung nach den Merkmalen des Oberbegriffs des Anspruchs 10 und eine Vorrichtung zum Aufbringen von Verbindungselementen nach den Merkmalen des Oberbegriffs des Anspruchs 15.

Gegenwärtig erfolgt die Kontaktierung von Halbleiterchips mit Hügelkontakten durch Aufbringen eines Klebers auf den gesamten Kontaktierbereich, wobei der Kleber nicht leitend, elektrisch leitend oder anisotrop leitend sein kann, danach das Positionieren und das Aufsetzen des Chips mit den Kontakthügeln auf den Kontaktierbereich. Schließlich erfolgt unter Andrücken des Chips mittels einer auf seine Rückseite drückenden, beheizten Thermode gegen die Leiterbahnen (foot print) im Kontaktierbereich die elektrische Kontaktierung und die mechanisch feste Verklebung des Chips mit dem Untergrund bzw. mit dem Substrat bzw. mit der Leiterplatte.

Nachteilig ist, dass für das Ausheizen und Aushärten des Klebers einige Sekunden Zeit benötigt werden und dass kostenaufwändige Vorkehrungen getroffen werden müssen, um die Verschmutzung der Thermoden durch den infolge Erwärmung vorübergehend niederviskos werdenden Kleber zu minimieren. Nachteilig ist weiterhin, dass das Substrat mit der Schaltung nach dem Bestücken des Chips vor dem Aufsetzen der Thermoden weiterbewegt wird bzw. weiterbewegt werden muss und dadurch sich die Lage der Chips zu dem Kontaktierbereich etwas verändern kann. Ein weiterer Nachteil liegt darin, dass nach Beanspruchung der Schaltung durch Feuchte und Wärme der Chipkleber aufquellen kann und so der elektrische Kontakt verschlechtert oder zerstört wird.

Bei einem optimierten Kontaktierverfahren werden die Anschlusshügel des Halbleiterchips nach dem Aufsetzen auf den Kontaktierbereich bzw. nach dem Eindrücken in den Kleber zusätzlich durch einen auf die Chiprückseite übertragenen Ultraschallimpuls mit den Leiterbahnen der Schaltung verschweißt. Nachteilig ist, dass dieses Ultraschallschweißen sich nur für wenige Qualitäten der Leitermaterialien eignet.

Bei einem weiteren Kontaktierverfahren erfolgt die Verbindung zwischen den Anschlusshügeln des Halbleiterchips und den Leiterbahnen durch das Löten. Nachteilig dabei ist, dass ein Lothilfsmittel (Lötpaste mit Flussmittel) zuvor auf die Leiterbahnen gedruckt werden muss und dass für die Lötkontaktierung die Kontaktmaterialien auf eine relativ hohe Temperatur für größer gleich 1 Sekunde erwärmt werden müssen, wodurch zumindest die zur Herstellung von Chipkarten verwendeten thermoplastischen Folien geschädigt werden können.

Eine Verbesserung der Zuverlässigkeit der Kontakte geklebter Halbleiterchips mit Anschlusshügeln ergibt sich bei Verwendung von mikrobucklig gestalteten Anschlusshügeln. Die Knospen jedes Hügels drücken sich mehr oder minder stark in das Kontaktmaterial auf dem Substrat ein und zerstören eventuelle Oxidhäute. Nachteilig ist, dass das zeitaufwändige Ausheizen des Chipklebers (Underfiller) und die latente Gefahr der Verschmutzung der Thermoden weiterhin bestehen.

Bisher ungenügend gelöst ist das Problem der Kontaktierung von Halbleiterchips direkt mit elektrisch leitenden Fasern von Geweben, Papieren, Vliesen und Folien. Das alleinige Verklemmen von flächigen Kontakten ist für eine dauerhafte Kontaktierung nicht ausreichend. Die in WO 2006/094989 A1 vorgeschlagene Lösung der Deponierung sehr kleiner elektrisch leitender Haken- und Ösenfasern auf den Fügeflächen von Substrat und Halbleiterchip ist sehr kostenaufwändig und die Zuverlässigkeit der Kontakte ist infolge des Aufquellens der Fasern unter Feuchteeinfluss nicht gesichert.

Aus der US 5,487,999 ist ein Verfahren zur Herstellung eines begrenzt eindringenden Kontaktes mit einer aufgerauten Oberfläche bekannt. Die Kontakte sind als erhabene

Elemente auf einem Substrat ausgeformt. Jeder Kontakt weißt eine aufgeraute Oberfläche auf, wobei die Oberflächenunebenheiten geeignet sind, in den Kontaktbereich des Halbleiterkontaktes bis zu einer begrenzten Tiefe einzudringen. Die aufgeraute Oberfläche und Oberflächenrauigkeiten werden durch Galvanisieren einer rauen Metallschicht auf ein erhabenes metallisches Kontaktelement oder durch Ätzen einer Oberfläche eines erhabenen metallischen Kontaktelementes erzeugt. In einer Ausführungsform weisen die Kontakte Mikrounebenheiten auf einem Polyimid-Substrat auf.

In der US 6,133,066 wird ein Verfahren zur Montage eines Halbleiterelementes beschrieben. Es werden Kontaktbereiche auf einem Substrat ausgeformt, eine Oberfläche zumindest eines Kontaktbereichs aufgeraut, ein Kleber zwischen einem Halbleiterelement mit Elektroden und dem Substrat platziert und die Elektroden mit den aufgerauten Kontaktstellen kontaktiert.

In der US 6,119,919 werden ein Verfahren und eine Vorrichtung zur Reparatur defekter Lotverbindungsstellen beschrieben. Im Verfahren wird in einem ersten Verfahrensschritt eine Lotmaterialhandhabungseinrichtung mit einer Lotmaterialabnahmeeinrichtung an einer Lotmaterialfehlstelle platziert und ein fehlerhaftes Lotmaterialdepot aus der Verbindung mit einem Lotmaterialträger gelöst und abgenommen. In einem zweiten Verfahrensschritt wird eine Lotmaterialeinheit aus einer an der Lotmaterialfehlstelle platzierten Lotmaterialapplikationseinrichtung der Lotmaterialhandhabungseinrichtung auf den Lotmaterialträger aufgebracht und mit dem Lotmaterialträger verbunden.

Aus der US 4,871,110 sind ein Verfahren und eine Vorrichtung zum Ausrichten von Lötkugeln bekannt. Die Lötkugeln werden auf eine Ausrichtplatte mit darin ausgebildeten ausgerichteten Durchgangslöchern aufgebracht. Luft wird von der Unterseite der Ausrichtplatte angesaugt, um Lötkugeln in die Durchgangslöcher einzupassen und anzuziehen.

Der Erfindung liegt die Aufgabe zugrunde, eine Schaltungsanordnung mit zuverlässigen elektrischen und mechanischen Verbindungen, ein kostengünstiges Verfahren zum sicheren elektrischen und mechanischen Verbinden von Verbindungspartnern einer Schaltungsanordnung und eine Vorrichtung zum Aufbringen von Verbindungselementen auf eine Verbindungsfläche anzugeben.

Die Aufgabe wird erfindungsgemäß gelöst durch eine Schaltungsanordnung mit den Merkmalen des Anspruchs 1, ein Verfahren zum elektrischen und mechanischen Verbinden von Verbindungspartnern einer Schaltungsanordnung mit den Merkmalen des Anspruchs 10 und eine Vorrichtung zum Aufbringen von Verbindungselementen auf eine Verbindungsfläche mit den Merkmalen des Anspruchs 15.

Vorteilhafte Ausgestaltungen der Erfindung sind Gegenstand der Unteransprüche.

Eine Schaltungsanordnung umfasst zumindest zwei Verbindungspartner, welche über Verbindungsflächen elektrisch und/oder mechanisch miteinander verbunden sind, wobei die Verbindungspartner Leiterbahnen, elektrisch leitfähige Fasermaterialien und/oder elektronische Bauelemente sind.

Erfindungsgemäß ist zwischen den Verbindungsflächen zumindest ein Verbindungselement angeordnet, welches Hinterschneidungen aufweist und mit einer der Verbindungsflächen formschlüssig und/oder stoffschlüssig elektrisch und mechanisch verbunden ist und mit der jeweils anderen Verbindungsfläche formschlüssig elektrisch und mechanisch verbunden ist. Vorteilhafterweise sind eine Mehrzahl von Verbindungselementen zwischen den Verbindungsflächen angeordnet und mit zumindest einer Verbindungsfläche formschlüssig und/oder stoffschlüssig verbunden. Vorzugsweise ist das Verbindungselement mit beiden Verbindungsflächen formschlüssig und/oder kraftschlüssig verbunden, zweckmäßigerweise, indem das Verbindungselement in ein Material zumindest einer Verbindungsfläche, bevorzugt beider Verbindungsflächen, teilweise eingepresst ist.

Dadurch ist eine optimale, kostengünstige und in einem Produktionsprozess schnell und mit geringem Aufwand zu realisierende elektrische und mechanische Verbindung zwischen den Verbindungspartnern hergestellt. Eine Positionsänderung der Verbindungspartner und eine daraus resultierende Zerstörung der Verbindung ist durch die Verbindungselemente unterbunden. Durch das form- und/oder stoffschlüssige Verbinden der Verbindungselemente mit beiden Verbindungsflächen ist die elektrische und mechanische Verbindung weiterhin optimiert.

Die Leiterbahnen, in welche die Verbindungselemente eindrückbar oder durch welche sie hindurch drückbar sind, können beispielsweise gedruckte, geätzte oder durch Verlegetechnik auf ein Substrat aufgebrachte Leiterbahnen sein.

Das Verbindungselement ist vorzugsweise kugelförmig, quaderähnlich, vieleckig, elliptisch, länglich, pyramidenförmig oder spitzkegelig ausgeformt ist, wodurch eine optimale Verankerung in den Verbindungsflächen erreichbar ist.

Das länglich, pyramidenförmig oder spitzkegelig ausgeformte Verbindungselement ist in einer vorteilhaften Ausführungsform geneigt auf der Verbindungsfläche angeordnet, d. h. in einem Winkel kleiner als 90°, und vorzugsweise zumindest abschnittsweise aus einem duktilen Material. Dadurch ist das Verbindungselement insbesondere zur Verbindung eines elektronischen Bauelementes mit elektrisch leitfähigem Fasermaterial geeignet. Es ist durch dieses Fasermaterial hindurch pressbar und verbiegbar, so dass das elektronische Bauelement optimal verankert ist.

Vorzugsweise sind auf einer Oberfläche des Verbindungselementes Poren, Kanten, Spratzer, Spikes, Kavitäten, Kavernen, Mikrokugeln und/oder Knospen ausgebildet und/oder es ist eine aufgeraute Oberflächenstruktur ausgebildet. Diese Ausbildungen auf der Oberfläche des Verbindungselementes weisen vorzugsweise eine Größe, d. h. eine größte Längsausdehnung und/oder einen Durchmesser einer größten Ausdehnung von 1 µm bis 5 µm auf.

Ein Durchmesser einer größten Ausdehnung der Verbindungselemente beträgt vorzugsweise 3 µm bis 50 µm, besonders bevorzugt 5 µm bis 30 µm bei kugelförmig, quaderähnlich oder vieleckig ausgeformten Verbindungselementen. Eine Längsausdehnung beträgt bis zu 500 µm, bevorzugt bis zu 100 µm bei sich längserstreckenden und/oder dornartigen Ausformungen, d. h. bei den länglich, pyramidenförmig oder spitzkegelig ausgeformten Verbindungselementen.

Bevorzugt ist das Verbindungselement aus einem härteren Material als die Verbindungsflächen, so dass es optimal in die Verbindungsflächen einpressbar und dort verankerbar ist.

Das Verbindungselement ist vorzugsweise aus einem korrosionsarmen oder korrosionsfreien Metall, beispielsweise Nickel, Edelstahl, Werkzeugstahl, beispielsweise aus dem Stahl 17.4 PH, oder einer harten Bronze, oder in einer weitem vorteilhaften Ausführungsform aus einem metallisierten keramischen Material hoher Festigkeit und Härte.

Das Verbindungselement ist bevorzugt aus einem magnetischen Material. Dadurch sind eine Mehrzahl Verbindungselemente durch ein zumindest zeitweise magnetisierbares Aufbringwerkzeug aufnehmbar, beispielsweise aus einem flächenhaften Verbindungselementespeicher, und in die Verbindungsfläche eindrückbar.

Zweckmäßigerweise ist das Verbindungselement mit einer bis zu 0,5 µm dicken duktilen Edelmetallschicht, insbesondere Silber, überzogen. Dadurch ist eine elektrische Leitfähigkeit verbessert und die Verbindungselemente sind leichter in die Verbindungsflächen einpressbar.

In einer vorteilhaften Ausführungsform ist zwischen den Verbindungsflächen zumindest eine Schicht Isolierlack angeordnet, welche von dem Verbindungselement durchdrungen ist. Diese Isolierlackschicht ist während des Zusammenfügens der Verbindungsflächen aufschmelzbar, so dass die Verbindungsflächen nach dem Zusammenfügen durch den Isolierlack vorteilhafterweise zusätzlich verklebt sind. In einer weiteren vorteilhaften Ausführungsform sind die Verbindungsflächen durch Vergussmasse und/oder einen elektrisch leitenden oder elektrisch nicht leitenden Kleber miteinander verklebt.

In einer bevorzugten Ausführungsform sind zwischen den Verbindungsflächen eine Mehrzahl gleichartiger oder unterschiedlich ausgeformter und/oder aus unterschiedlichem Material gebildeter Verbindungselemente angeordnet, welche bevorzugt netzartig, ringförmig oder zu Nadeln angeordnet und miteinander verbunden sind, wodurch die elektrische und mechanische Verbindung optimiert ist und eine Dauerhaftigkeit der Verbindung sichergestellt ist.

In einem Verfahren zum elektrischen und mechanischen Verbinden von Verbindungspartnern einer Schaltungsanordnung, wobei die Verbindungspartner Leiterbahnen, elektrisch leitfähige Fasermaterialien und/oder elektronische Bauelemente sind, wird erfindungsgemäß in einem ersten Schritt auf zumindest einer Verbindungsfläche zumindest eines Verbindungspartners zumindest ein Verbindungselement, welches Hinterschneidungen aufweist, angeordnet und/oder durch eine Bearbeitung zumindest einer Verbindungsfläche zumindest eines Verbindungspartners stoffschlüssig elektrisch und mechanisch verbunden erzeugt und in einem zweiten Schritt werden die Verbindungsflächen der Verbindungspartner übereinander positioniert und unter Druckbeaufschlagung miteinander elektrisch und mechanisch verbunden werden, wobei das zumindest eine Verbindungselement mit zumindest einer der Verbindungsflächen formschlüssig elektrisch und mechanisch verbunden wird.

Es werden metallische oder mit elektrisch leitenden Metallen überzogene Verbindungselemente hoher Festigkeit verwendet, die zwischen die Verbindungsflächen der Verbindungspartner eingebracht oder auf den Verbindungsflächen eines oder beider Verbindungspartner befestigt werden, die unter der auf die Verbindungspartner bei einem Zusammenfügen ausgeübten mechanischen Druckbeaufschlagung unter Verdrängung von duktilem Material eines oder beider Verbindungspartner in das Material eingepresst werden, die sich aufgrund einer durch Hinterschneidungen geprägten Verbindungselementstruktur im Material der Verbindungsfläche verhaken und die eine mechanische und elektrische Verbindung zwischen den Verbindungsflächen der zu verbindenden Verbindungspartner, d. h. von Leiterbahnen, Bauelementen und Halbleiterchips herstellen.

Die Leiterbahnen, in welche die Verbindungselemente eingedrückt oder durch welche sie hindurch gedrückt werden, können beispielsweise gedruckte, geätzte oder durch Verlegetechnik auf ein Substrat aufgebrachte Leiterbahnen sein.

Die Verbindungselemente bestehen vorteilhaft aus einem gegenüber dem Material zumindest einer Verbindungsfläche signifikant härteren und festeren Material. Das Verhaken erfolgt durch Einpressen des duktilen Materiales eines oder beider Verbindungsflächen in eine bezüglich der Fügerichtung durch Hinterschneidungen gekennzeichnete Oberfläche der Verbindungselemente. Dementsprechend sind die Verbindungselemente domartige oder sphärische, regelmäßig oder unregelmäßig geformte Körper mit spratzigen, porigen, kristallitisch rauen, gekerbten, knospigen oder durch Kavitäten unterbrochenen oder mit Spikes oder mit Schuppen besetzten Oberflächen. Vorteilhaft ist es, wenn die Verbindungselemente spratzig gestaltet sind oder das Aussehen einer beerenförmigen Verbackung von Mikrokugeln oder unregelmäßig geformter Metallpulver aufweisen. Beim Eindrücken in das duktile Material der Verbindungsfläche fließt das Material zwischen die Spratzer oder die Mikrokugeln bzw. Körner der Verbindungselemente.

Es ist auch vorteilhaft die Verbindungselemente als mikrorauen, nahezu kugelförmigen Körper zu gestalten oder die Oberfläche der Verbindungselemente oder der Verbindungsflächen durch Poren bzw. Kavitäten oder schuppenförmige Gestaltung mit Hinterschneidungen auszurüsten.

Bei einer weiteren Ausführungsform werden auf die Verbindungsflächen mindesten eines Verbindungspartners domartige Verbindungselemente aufgebracht, deren Oberflächen vorteilhaft mikrorau gestaltet sind. Ebenso ist es vorteilhaft knospenähnliche Verbindungselemente auf den Verbindungsflächen mindestens eines Verbindungspartners abzuscheiden.

In einer vorteilhaften Ausführungsform wird auf der Verbindungsfläche des ersten Verbindungspartners zumindest ein Verbindungselement angeordnet oder erzeugt und auf der Verbindungsfläche des zweiten Verbindungspartners wird durch Aufkerbungen, durch anisotropes Ätzen und/oder durch ein lasergestütztes Abtragen von Material der Verbindungsfläche eine mit dem zumindest einen Verbindungselement korrespondierende Oberflächenstruktur erzeugt. Beim anisotropen Ätzen von Materialien mit Mischkristallen wird ein Kristalltyp unter Hinterlassung von Kavitäten oder Kavernen herausgelöst. Derartige Ausformungen der korrespondierenden Oberflächenstruktur, d. h. die Aufkerbungen, Kavitäten oder Kavernen weisen vorzugsweise eine Größe, d. h. eine größte Längsausdehnung und/oder einen Durchmesser einer größten Ausdehnung von bis zu 10 µm auf.

Bei einem Materialabtrag durch Laserenergie werden durch schräg auf die Verbindungsflächen eingestrahlte Energie Hinterschneidungen eingearbeitet. Des Weiteren können durch eine gezielt schräg einkerbende mechanische Bearbeitung raue Hinterschneidungen erzeugt werden. Durch eine derartige, durch Umformen, additive oder subtraktive Materialbearbeitung erzeugte Oberflächenstruktur greifen die Verbindungselemente beim Zusammenfügen in die den Verbindungselementen ähnliche Oberflächenstruktur der Verbindungsfläche des Verbindungspartners mit einem Material hoher Festigkeit ein, so dass die elektrische und mechanische Verbindung optimiert ist.

Des Weiteren können durch einen derartigen Materialabtrag durch Laserenergie oder durch die gezielt schräg einkerbende mechanische Bearbeitung oder auch durch Ätzen, d. h. durch Umformen oder durch eine additive oder subtraktive Materialbearbeitung auch raue Hinterschneidungen als Verbindungselemente in die Verbindungsfläche des ersten Verbindungspartners eingearbeitet werden. Beim Zusammenfügen der Verbindungsfläche mit der Verbindungsfläche des zweiten Verbindungspartners, welche ein duktileres Material aufweist, verformt sich das Material der Verbindungsfläche des zweiten Verbindungspartners entsprechend der Verbindungselemente auf der Verbindungsfläche des ersten Verbindungspartners und fließt in die Hinterschneidungen der auf der Verbindungsfläche des ersten Verbindungspartners ausgeformten Verbindungselemente hinein, so dass die formschlüssige elektrische und mechanische Verbindung der Verbindungsflächen über die Verbindungselemente ausgebildet ist, wobei die Verbindungselemente auf diese Weise mit der Verbindungsfläche des ersten Verbindungspartners stoffschlüssig elektrisch und mechanisch verbunden sind und mit der Verbindungsfläche des zweiten Verbindungspartners formschlüssig elektrisch und mechanisch verbunden sind.

In einer vorteilhaften Ausführungsform wird das Verbindungselement durch galvanische und/oder chemische und/oder elektrolytischer Abscheidungen harter, rauer kristalliner, knospiger, mikroporöser oder schuppiger Metallschichten auf die Verbindungsfläche und/oder durch laserbewirktes Sintern und/oder durch ein Aufschmelzen auf die Verbindungsfläche nach einem so genannten rapid prototyping Verfahren erzeugt. Mit diesem Verfahren ist die gezielte Erzeugung von Verbindungselementegeometrien möglich, insbesondere von senkrecht oder in einem bestimmten Winkel zur Verbindungsfläche angeordneten dornförmigen Verbindungselementen oder Verbindungselementen ähnlicher Geometrien mit unterschiedlichen Materialeigenschaften in bestimmten Längenabschnitten des Verbindungselementes.

Eine weitere vorteilhafte Ergänzung parallel zur laserbewirkten Erzeugung der Verbindungselemente auf bestimmten Verbindungspartnern, zum Beispiel Halbleiterchips, ist die laserbewirkte Abscheidung bzw. Sinterung polymerer oder anorganischer Schichten zum Schutz empfindlicher Bauelementeoberflächen.

Chipkontaktstellen weisen vorteilhaft vor dem laserbewirkten Abscheiden von Verbindungselementen bereits einen flachen Kontakthügel, zum Beispiel aus Nickel auf, der von einem oder mehreren dornförmigen Verbindungselementen ausgehende Kräfte auf die Chipkontaktstelle aufnimmt und beim laserbewirkten Aufschmelzen eines Verbindungselementmaterials an die Chipkontaktstelle einen kurzzeitig und punktförmig auftretenden Energieeintrag aufnimmt und so eine Kontaktfläche zum Halbleiter schützt.

Ein Vorteil der additiven Verbindungselementerzeugung auf Chipanschlussflächen von noch in einem Waferverband befindlichen Chips ist eine kostengünstige, gezielte Geometrieerzeugung. Halbleiterchips mit dornförmigen Verbindungselementen sind vorteilhaft einsetzbar für eine Kontaktierung von Geweben, Papieren usw. mit elektrisch leitfähigen Fasern.

Bevorzugt wird vor dem Verbinden zweier Verbindungsflächen das Verbindungselement auf der Verbindungsfläche angeordnet, welches eine geringere Duktilität und/oder eine höhere Härte aufweist und teilweise in diese Verbindungsfläche eingepresst. In die andere Verbindungsfläche ist das Verbindungselement dann während des Zusammenfügens der Verbindungsflächen einpressbar.

Um das Einpressen zu ermöglichen oder zu erleichtern, wird ein Material der Verbindungsfläche zweckmäßigerweise durch thermische Energie oder mittels Ultraschall oder Niederfrequenzschwingungen erwärmt. Vorzugsweise wird das Material dadurch zumindest teilweise aufgeschmolzen.

In einer weiteren Ausführungsform wird vor dem Verbinden zweier Verbindungsflächen das Verbindungselement auf der Verbindungsfläche angeordnet, welche eine Oberflächenschicht aus einem duktilen Material aufweist und teilweise in diese Oberflächenschicht eingepresst, wobei eine Dicke der Oberflächenschicht einer Einpresstiefe des Verbindungselementes entspricht. Auf diese Weise ist das Verbindungselement oder sind eine Mehrzahl von Verbindungselementen auch mit Verbindungspartnern verbindbar, welche sehr harte Verbindungsflächen aufweisen, die ein Einpressen der Verbindungselemente erschweren. Durch die duktile Oberflächenschicht wird diese Verbindung ermöglicht. Diese Oberflächenschicht wird, um das Einpressen zu erleichtern, zweckmäßigerweise durch thermische Energie oder mittels Ultraschall erwärmt. Vorzugsweise wird die Oberflächenschicht dabei zumindest teilweise aufgeschmolzen.

In einer vorteilhaften Ausführungsform wird vor dem Verbinden und/oder während des Verbindens zweier Verbindungsflächen ein auf zumindest einer Verbindungsfläche angeordneter Isolierlack durch thermische Energie oder mittels Ultraschall erwärmt. Vorzugsweise wird der Isolierlack dabei zumindest teilweise aufgeschmolzen. Die Verbindungselemente werden durch den Isolierlack hindurch in das Material der Verbindungsflächen eingepresst. Bei einer Isolierung oder zumindest einer äußeren Schicht der Isolierung aus Schmelzkleber und bei einem Einpressen der Verbindungselemente und Zusammendrücken der Verbindungsflächen bei Temperaturen größer oder gleich einer Schmelztemperatur des Schmelzklebers werden die Verbindungsflächen durch den Isolierlack geschützt und gleichzeitig durch den Schmelzkleber verklebt. Ebenso kann durch nachträgliche Erwärmung des Schmelzklebers auf Temperaturen größer oder gleich der Schmelztemperatur, etwa beim Laminieren, der Kleber aufgeschmolzen und es können die Verbindungsflächen verklebt werden.

In einer weiteren vorteilhaften Ausführungsform wird vor dem Verbinden zweier Verbindungsflächen ein elektrisch leitender oder elektrisch nicht leitender Kleber auf zumindest eine Verbindungsfläche aufgebracht oder auf zumindest eine Verbindungsfläche ein flüssiger oder aufschmelzbarer Sicherungskleber aufgebracht und während des Verbindens und/oder nach dem Verbinden durch Erwärmen kurzzeitig aufgeschmolzen und/oder ausgehärtet. In einer vorteilhaften Ausführungsform wird der flüssige oder aufschmelzbare Sicherungskleber auf eine gewebeartige Verbindungsfläche aufgebracht und zumindest ein Verbindungselement wird während des Verbindens in die gewebeartige Verbindungsfläche eingedrückt, wobei der flüssige oder aufschmelzbare Sicherungskleber das zumindest eine Verbindungselement nach einem Aushärten mit der gewebeartigen Verbindungsfläche verklebt. Der flüssige oder aufschmelzbare Sicherungskleber eignet sich insbesondere für gewebeartige Verbindungsflächen. Im flüssigen Zustand dringt er vorzugsweise teilweise in das Gewebe ein, so dass der Sicherungskleber die Verbindungselemente im Gewebe umschließt und mit dem Gewebe verklebt und/oder die Verbindungselemente zwischen den Verbindungsschichten umschließt und nach dem Aushärten optimal haltert und/oder die Verbindungsflächen miteinander verklebt. Des Weiteren kann vor dem Verbinden und/oder nach dem Verbinden zweier Verbindungsflächen eine Vergussmasse zwischen die Verbindungsflächen eingebracht und ausgehärtet werden. Dadurch werden die Verbindungsflächen geschützt und mechanisch sicherer verbunden. Es ergeben sich dadurch feste Verbünde der zu verbindenden Verbindungspartner, wie beispielsweise Leiterbahnen und Bauelemente, mit einem hermetischem Schutz von Zwischenräumen und Spalten und einer Oberfläche der Halbleiterchips vor Feuchte und mechanischen Zerstörungen.

Durch Kleber oder Vergussmasse zwischen den Verbindungsflächen ist es auch möglich, die Verbindungselemente derart anzubringen, dass sie sich nicht in den Verbindungsflächen der Verbindungspartner verhaken, sondern sie sind zwischen die Verbindungsflächen der Verbindungspartner eingebracht und leicht eingedrückt, ohne sich zu verhaken. In einen Zwischenraum zwischen den Verbindungspartnern ist aushärtbarer, elektrisch leitender oder nicht leitender Kleber eingebracht. Durch die Verbindungselemente wird die elektrische Verbindung vollzogen und durch den Kleber die mechanische Verbindung.

Bei einer weiteren Ausführungsform werden vor dem Verbinden in eine oder beide Verbindungsflächen Verbindungselemente eingedrückt. Die elektrische und mechanische Verbindung der beabstandeten Verbindungsflächen erfolgt durch einen den Zwischenraum ausfüllenden, elektrisch leitenden Kleber. Die in die Verbindungsflächen eingedrückten Verbindungselemente berühren nicht die jeweils andere Verbindungsfläche. Die Verbindungselemente verstärken die Befestigung und sichern die Verklebung des elektrisch leitenden Klebers mit den Verbindunsgsflächen. Die Verbindungselemente können ebenfalls zur Festigkeitsverbesserung rein mechanischer Klebeverbindungen eingesetzt werden.

Eine weitere vorteilhafte Verfahrensweise und Anordnung zur Sicherung der Verbindung von Bauelementen und/oder Leiterbahnen untereinander besteht darin, eine zusätzliche Sicherung der Verbindung durch einen Formschluss und/oder durch permanent wirkende Druckkräfte vorzunehmen, die im wesentlichen über Rückseiten der Leiterbahnen oder elektronischen Bauelemente senkrecht auf die Verbindungsflächen wirken. Dies erfolgt beispielsweise durch eine Einlaminierung der Schaltungsanordnung in Deckfolie. Damit wird ein Herausziehen der Verbindungselemente aus dem Material der Verbindungsflächen unterbunden, aber eine begrenzte seitliche Bewegung bzw. Verschiebung der Verbindungsflächenpaare, zum Beispiel aufgrund von Temperaturunterschieden oder aufgrund seitlicher Kräfte bei einem Laminieren, ist möglich, ohne eine elektrische Kontaktgabe zu beeinträchtigen.

Des Weiteren ist es vorteilhaft, die Verbindungselemente in eine sehr dünne Schmelzklebefolie einzubetten und diese Schmelzklebefolie zwischen die Verbindungsflächen der Verbindungspartner zu legen und unter heißem Zusammendrücken sowohl ein Verhaken der Verbindungspartner als auch unter einem teilweisen oder völligen Herausquetschen des geschmolzenen Klebers aus der Verbindungsfläche eine Abdichtung einer Kontaktstelle zwischen den Verbindungsflächen als auch eine zusätzliche Klebeverbindung der Verbindungspartner zu erreichen.

In einer vorteilhaften Ausführungsform wird das Verbindungselement nach dem Verbinden verformt. Dabei ist es sehr günstig, für eine Kontaktierung von elektrisch leitfähigen Geweben und ähnlichen Materialien vorgesehene Verbindungselemente in bestimmten Längenabschnitten oder über eine gesamte Länge eines dornförmigen (harpunenartigen) Körpers aus duktilen Metallen herzustellen, um eine unnötige Krafteinleitung beispielsweise auf die Chipkontaktstellen zu vermeiden und zugleich die Möglichkeit zu schaffen, durch Druck auf durch bzw. in das Gewebe gestoßene Dornspitzen die Dornspitze abzubiegen und somit eine bessere Verankerung im Gewebe oder ähnlichen Materialien zu bewirken und eine Fühlbarkeit der Dornspitzen zu vermindern bzw. zu vermeiden. Leicht schräg zur Halbleiteroberfläche angeordnete dornförmige Verbindungselemente erleichtern das gezielte Verbiegen der Dornspitzen.

Weiterhin ist die Verankerung der dornförmigen Verbindungselemente im Gewebe oder ähnlichen Materialien zu verbessern durch Aufbringen eines härtbaren, elastischen oder bedingt plastischen Klebers oder eines flüssigen und aushärtbaren Sicherungsklebers oder eines kurzzeitig aufschmelzbaren Sicherungsklebers auf oder in das Gewebe oder zwischen Gewebe und Halbleiterchip vor dem Fügevorgang. Gewebe und Vliese, Papiere und ähnliche Materialien mit elektrisch leitfähigen Oberflächen oder Imprägnierungen lassen sich einfach und dauerhaft und sehr kostengünstig mit Halbleiterchips und/oder elektronischen oder elektrischen Bauelementen, deren Verbindungsflächen Verbindungselemente aufweisen, mechanisch und elektrisch verbinden. Die Kontakte können durch härtbare, elastische oder bedingt plastische Kleber geschützt und gesichert werden.

Eine Vorrichtung zum Aufbringen von Verbindungselementen auf eine Verbindungsfläche umfasst ein Aufbringwerkzeug und einen Verbindungselementespeicher. Erfindungsgemäß ist das Aufbringwerkzeug zeitweise magnetisierbar und weist eine rasterartige Wirkfläche auf. Mittels dieses Aufbringwerkzeugs sind erfindungsgemäß eine Mehrzahl magnetischer Verbindungselemente aus dem flächenhaften Verbindungselementespeicher aufnehmbar und in die Verbindungsfläche eindrückbar. Durch die rasterartige Wirkfläche des Werkzeuges ist eine optimale Verteilung und Dichte der Verbindungselemente sichergestellt.

Ausführungsbeispiele der Erfindung werden im Folgenden anhand von Zeichnungen näher erläutert.

Darin zeigen:
- Figur 1A: eine schematische Darstellungen einer Ausführungsform eines Verbindungselementes,
- Figur 1B: eine schematische Darstellungen einer weiteren Ausführungsform eines Verbindungselementes,
- Figur 1C: eine schematische Darstellungen einer weiteren Ausführungsform eines Verbindungselementes,
- Figur 1D: eine schematische Darstellungen einer weiteren Ausführungsform eines Verbindungselementes,
- Figur 1E: eine schematische Darstellungen von auf einer Verbindungsfläche erzeugten Verbindungselementen,
- Figur 1F: eine schematische Darstellung einer Verbindungsfläche mit einer zu Verbindungselementen korrespondierenden Oberflächenstruktur,
- Figur 1G: eine schematische Darstellungen einer weiteren Ausführungsform von auf einer Verbindungsfläche erzeugten Verbindungselementen,
- Figur 1H: eine schematische Darstellung einer bearbeiteten Verbindungsfläche,
- Figur 1I: eine schematische Darstellung einer Netzstruktur einer Mehrzahl von Verbindungselementen,
- Figur 2: eine schematische Darstellung eines mit einer Verbindungsfläche verbundenen Verbindungselementes,
- Figur 3: ein schematische Darstellung eines zwei Verbindungspartner verbindenden Verbindungselementes,
- Figur 4: eine schematische Darstellung mehrerer Verbindungspartner vor einer Verbindung,
- Figur 5: eine schematische Darstellung einer Mehrzahl mit einer Verbindungsfläche verbundener Verbindungselemente,
- Figur 6: eine schematische Darstellung einer weiteren Ausführungsform einer Mehrzahl mit einer Verbindungsfläche verbundener Verbindungselemente,

- Figur 7: eine schematische Darstellung durch Verbindungselemente verbundener Verbindungspartner,
- Figur 8: eine schematische Darstellung einer weiteren Ausführungsform durch Verbindungselemente verbundener Verbindungspartner,
- Figur 9: eine schematische Darstellung einer Vorrichtung zum Aufbringen von Verbindungselementen,
- Figur 10: eine schematische Darstellung einer weiteren Ausführungsform durch Verbindungselemente verbundener Verbindungspartner,
- Figur 11: eine schematische Darstellungen einer weiteren Ausführungsform von auf einer Verbindungsfläche erzeugten Verbindungselementen,
- Figur 12: eine schematische Darstellung einer weiteren Ausführungsform durch Verbindungselemente verbundener Verbindungspartner,
- Figur 13: eine schematische Darstellung einer weiteren Ausführungsform durch Verbindungselemente verbundener Verbindungspartner,
- Figur 14: eine schematische Darstellung einer weiteren Ausführungsform durch Verbindungselemente verbundener Verbindungspartner, und
- Figur 15: eine schematische Darstellung einer weiteren Ausführungsform durch Verbindungselemente verbundener Verbindungspartner.

Einander entsprechende Teile sind in allen Figuren mit den gleichen Bezugszeichen versehen.

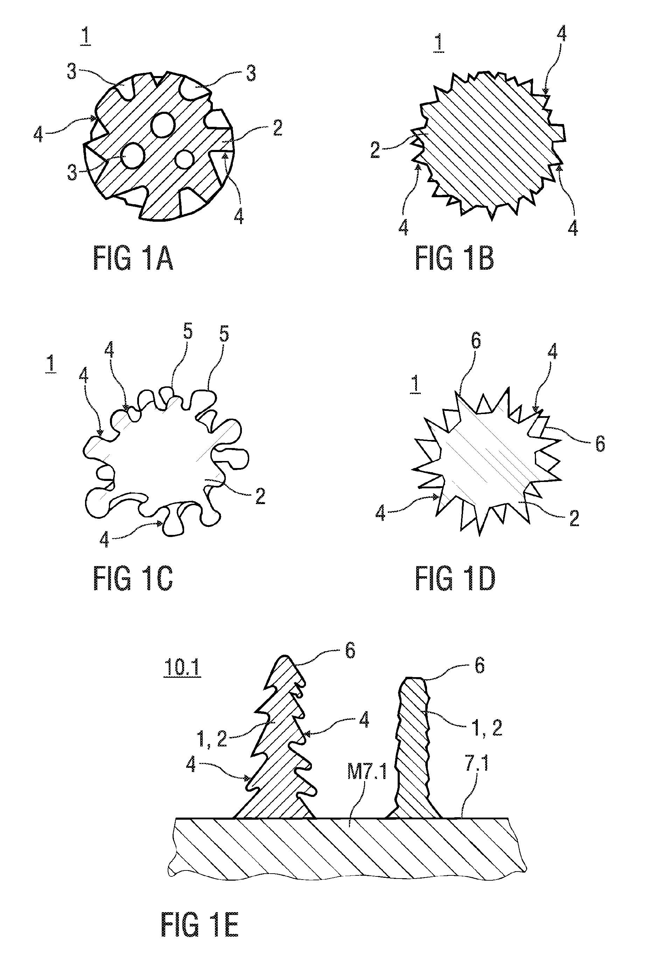

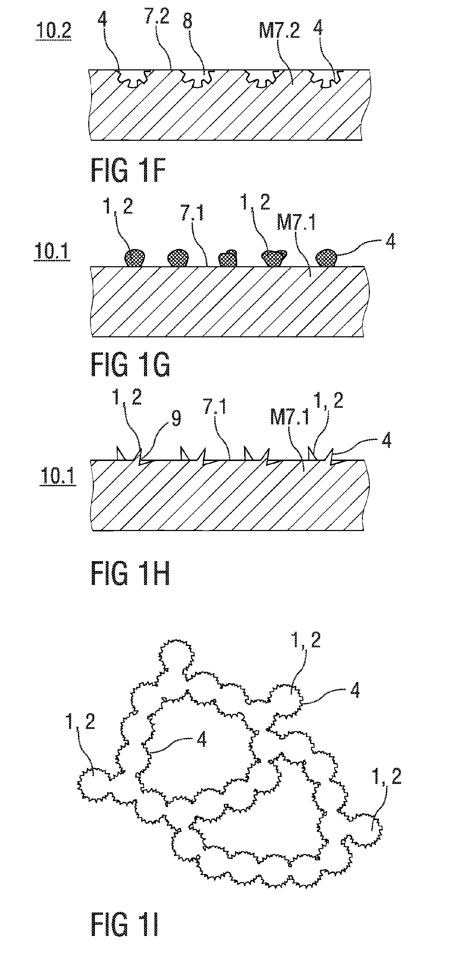

Figur 1A zeigt im Querschnitt einen nahezu kugelförmigen Körper eines Verbindungselementes 1, wobei eine Oberfläche 2 des Verbindungselementes 1 Poren 3 aufweist. Auch in einem Körpervolumen des Verbindungselementes 1 können Poren 3 vorhanden sein. Wandungen der Poren 3 bilden Hinterschneidungen 4.

Das Verbindungselement 1 in Figur 1B weist eine aufgeraute, kristallitische Oberflächen 2 auf, eine Rautiefe beträgt im Beispiel 2 µm. Hinterschneidungen 4 sind dementsprechend gering.

Größere Hinterschneidungen 4 weist das in Figur 1C dargestellte Verbindungselement 1 auf, dessen Oberfläche 2 durch Spratzer 5, das heißt durch tropfenförmige Ansätze, zerklüftet und vergrößert ist.

Ein Querschnitt des Verbindungselementes 1 in Figur 1D weist pyramidenförmige Spikes 6 auf, eine Länge der Spikes 6 beträgt bis zu 3 µm.

Die in Figur 1E im Querschnitt gezeigten Verbindungselemente 1 sind durch laserbewirktes Sintern durch Materialauftrag auf eine erste Verbindungsfläche 7.1 erzeugt worden. Die Verbindungselemente 1 sind nadelförmig bzw. domartig gestaltet, eine Länge der Verbindungselemente 1 beträgt im Beispiel 50 µm und ein Durchmesser 10 µm bis 25 µm.

Demgegenüber ist in Figur 1F im Querschnitt eine zweite Verbindungsfläche 7.2 dargestellt, wobei in ein Material M7.2 der zweiten Verbindungsfläche 7.2 mittels Nassätzverfahren Kavitäten 8 eingebracht wurden. Dadurch weist die zweite Verbindungsfläche 7.2 eine mit Verbindungselementen 1 korrespondierende Oberflächenstruktur auf. Wandungen der Kavitäten 8 weisen Rauhigkeiten auf, die als Hinterschneidungen 4 für ein beim Verbinden eingedrücktes Material M7.1 der ersten Verbindungsfläche 7.1 bzw. von Verbindungselementen 1 wirken.

Wirken diese Kavitäten 8 als Hinterschneidungen für das Material M7.1 der ersten Verbindungsfläche 7.1, so sind die Kavitäten 8 selbst die Verbindungselemente 1. In diesem Fall ist das Material M7.1 der ersten Verbindungsfläche 7.1 duktiler als das Material M7.2 der zweiten Verbindungsfläche 7.2, so dass das Material M7.1 der ersten Verbindungsfläche 7.1 während des Verbindens, d. h. durch das Zusammenpressen sich verformt und in die Kavitäten 8 der zweiten Verbindungsfläche 7.2 hineinfließt. Dadurch ist die formschlüssige elektrische und mechanische Verbindung der Verbindungsflächen 7.1, 7.2 über die als Kavitäten 8 ausgebildeten Verbindungselemente 1 hergestellt, wobei die Verbindungselemente 1 auf diese Weise mit der zweiten Verbindungsfläche 7.2 stoffschlüssig elektrisch und mechanisch verbunden sind und mit der ersten Verbindungsfläche 7.1 formschlüssig elektrisch und mechanisch verbunden sind.

Auf die in Figur 1G im Querschnitt gezeigte erste Verbindungsfläche 7.1 sind elektrochemisch als Knospen ausgeformte Verbindungselemente 1 mit einem Durchmesser von etwa 3 µm abgeschieden. Das Material M7.1 der ersten Verbindungsfläche 7.1 im Beispiel besteht aus Kupfer, die knospenförmigen Verbindungselemente 1 bestehen aus Palladium mit einem erhöhten Glanzbildneranteil.

In Figur 1H sind auf der ersten Verbindungsfläche 7.1 durch schräge Aufkerbungen 9 Verbindungselemente 1 bzw. eine mit Verbindungselementen 1 korrespondierende Oberflächenstruktur ausgebildet. Das Material M7.1 der ersten Verbindungsfläche 7.1 besteht aus harter Bronze, eine Höhe der Aufkerbung 9 beträgt 4 µm. Sind die Aufkerbungen 9 als Verbindungselemente 1 ausgebildet, so verformt sich beim Zusammenpressen der Verbindungsflächen 7.1, 7.2 das Material M7.2 der zweiten Verbindungsfläche 7.2, welches duktiler ist als das Material M7.1 der ersten Verbindungsfläche M7.1, und fließt in durch die Aufkerbungen 9 gebildete Hinterschneidungen hinein. Dadurch ist die formschlüssige elektrische und mechanische Verbindung der Verbindungsflächen 7.1, 7.2 über die als Aufkerbungen 9 ausgebildeten Verbindungselemente 1 hergestellt, wobei die Verbindungselemente 1 auf diese Weise mit der ersten Verbindungsfläche 7.1 stoffschlüssig elektrisch und mechanisch verbunden sind und mit der zweiten Verbindungsfläche 7.2 formschlüssig elektrisch und mechanisch verbunden sind.

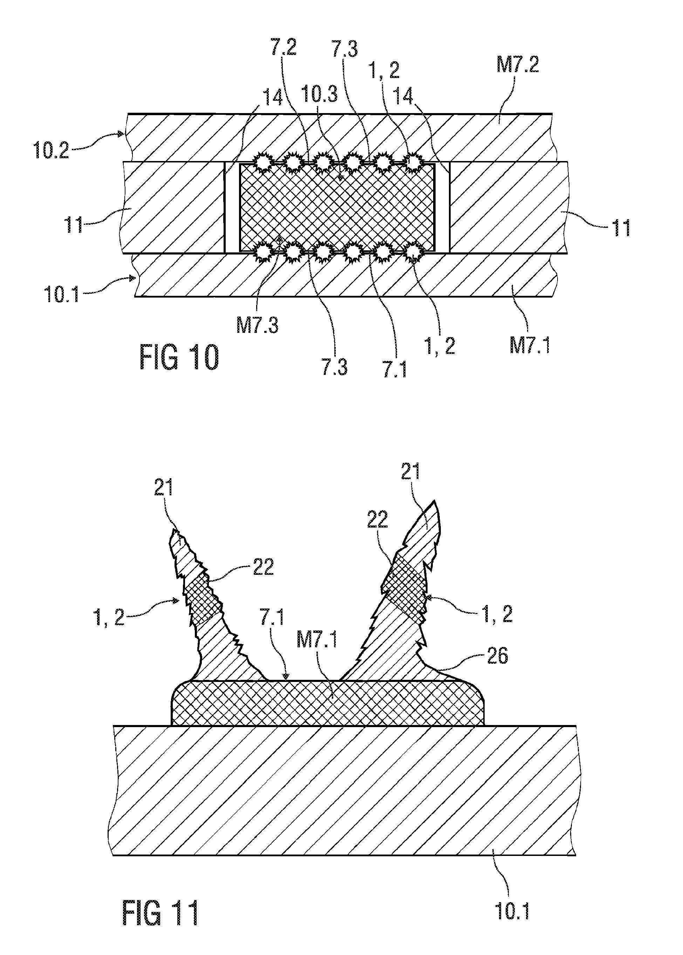

In der Draufsicht in Figur 11 dargestellt sind zu nahezu ebenen netzartigen Gebilden zusammengesinterte Verbindungselemente 1. Die Verbindungselemente 1 bestehen aus rostfreiem Werkzeugstahl.

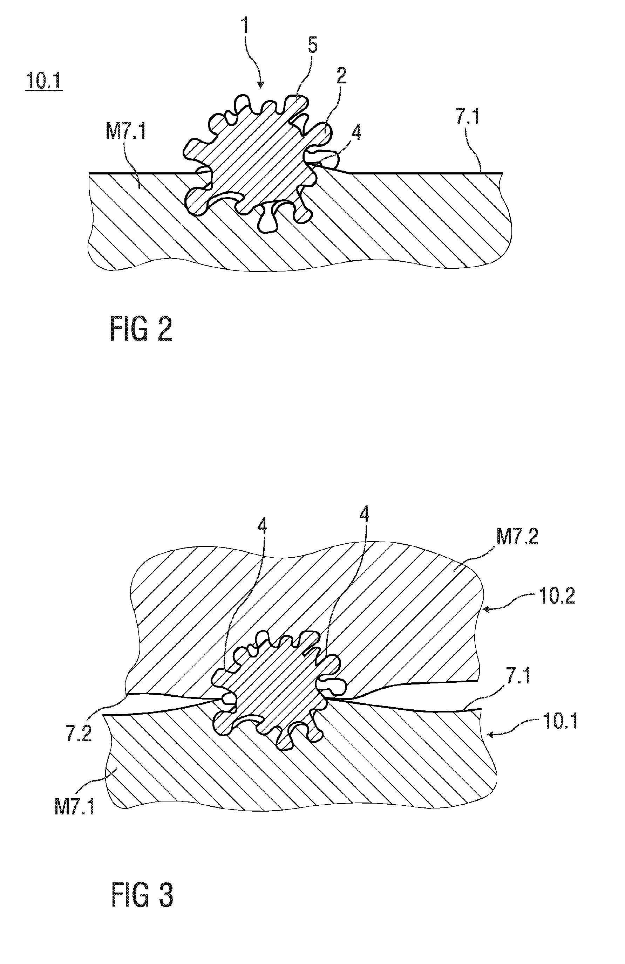

Figur 2 zeigt im Querschnitt ein Verbindungselement 1, welches in weiches Kupfer als Material M7.1 der ersten Verbindungsfläche 7.1 eingedrückt ist. Das Verbindungselement 1 ist aus Werkzeugstahl 316L und weist Spratzer 5 auf. Beim Einpressen des Verbindungselementes 1 wird das duktile Kupfer verdrängt und drückt sich so um die Spratzer 5, dass die Hinterschneidungen 4 durch die Materialverdrängung teilweise mit Kupfer ausgefüllt werden. Das Verbindungselement 1 ist damit im Material M7.1 der ersten Verbindungsfläche 7.1 verhakt.

Nach Auflegen und Eindrücken der zweiten Verbindungsfläche 7.2 welche ebenfalls duktiles Material M7.2 aufweist, ergibt sich eine in Figur 3 im Querschnitt dargestellte Verbindung zweier Verbindungspartner 10.1, 10.2. Beide Verbindungsflächen 7.1, 7.2 der Verbindungspartner 10.1, 10.2 sind um das Verbindungselement 1 herum deformiert und berühren sich. Das Verbindungselement 1 ist formschlüssig mit den Materialien M7.1, M7.2 der Verbindungsflächen 7.1, 7.2 verbunden. Beim Einpressen des Verbindungselementes 1 wurde die Materialien M7.1, M7.2 teilweise verdrängt und lagerten sich in den Hinterschneidungen 4 des Verbindungselementes 1 an.

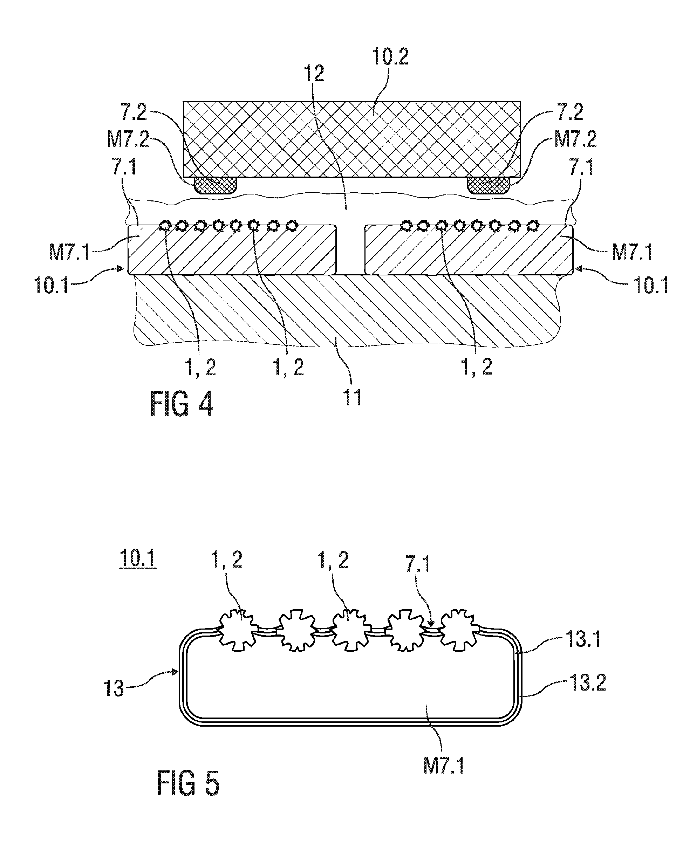

Figur 4 zeigt im Querschnitt einen Ausschnitt aus einem Substrat 11 mit zwei darauf befindlichen Leiterbahnen aus weichem Kupfermaterial, welche jeweils erste Verbindungspartner 10.1 sind und jeweils eine erste Verbindungsfläche 7.1 aufweisen. In das Material M7.1 der ersten Verbindungsflächen 7.1 sind bereits Verbindungselemente 1 in Form kristallitrauer, nahezu kugelförmiger Körper mit einem Durchmesser von 6 µm etwa 3 µm tief eingepresst worden. Auf die als Leiterbahnen ausgeformten ersten Verbindungspartner 10.1 und einen Zwischenraum zwischen diesen ist ein Kleber 12 als Underfiller aufgetragen.

Der zweite Verbindungspartner 10.2 ist ein elektronisches Bauelement, im hier dargestellten Ausführungsbeispiel ein Halbleiterchip. Dieser weist zwei Kontakthügel aus sehr duktilem Gold auf, welche jeweils als zweite Verbindungsflächen 7.2 dienen. Die Kontakthügel weisen eine Dicke von ca. 30 µm bis 40 µm auf und erstrecken sich über eine Fläche von 80 x 80 µm². Wird der zweite Verbindungspartner 10.2, d. h der Halbleiterchip, anschließend mit seinen als zweite Verbindungsflächen 7.2 dienenden Anschlusshügeln (Bumps) auf die Verbindungselemente 1 gedrückt, wird der Kleber 12 soweit verdrängt, dass ein Spalt zwischen den Verbindungspartnern 10.1, 10.2 und dem Substrat 11 vollständig durch den Kleber 12 ausgefüllt ist. Da die Verbindungspartner 10.1, 10.2 durch die Verbindungselemente 1 fest verbunden sind, muss im nachfolgenden Schritt eines Aushärtens des Klebers 12 unter Wärmeeinwirkung keine Thermode auf eine Rückseite des Halbleiterchips aufgesetzt werden.

Der in Figur 5 im Querschnitt gezeigte erste Verbindungspartner 10.1 in Form einer Leiterbahn weist allseitig einen Überzug aus einem elektrisch isolierendem Isolierlack 13 auf, bestehend aus einer direkt auf der Leiterbahn aus Kupfer aufgetragenen Kernlackschicht 13.1 und einer darauf befindlichen Backlackschicht 13.2. Die Verbindungselemente 1 aus Werkzeugstahl 316L und einem Größtmaß von 14 µm sind durch den Isolierlack 13 in das Material M7.1 der ersten Verbindungsfläche 7.1 des ersten Verbindungspartners 10.1 so tief eingedrückt, dass die Verbindungselemente 1 im Kupfer sicher verhakt sind. Für die künftige Verbindung mit der zweiten Verbindungsfläche 7.2 des zweiten Verbindungspartners 10.2 dienen ausschließlich die Verbindungselemente 1.

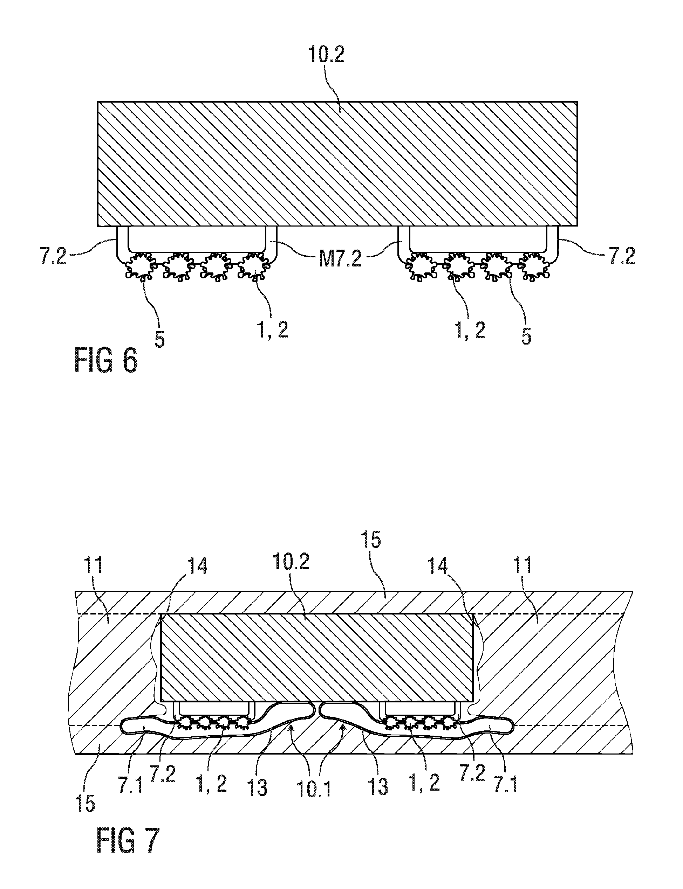

Figur 6 zeigt im Querschnitt Verbindungselemente 1 mit Spratzern 5, wobei die Verbindungselemente 1 in die als zweite Verbindungsfläche 7.2 dienenden Kontakthügel des als Halbleiterchip ausgebildeten zweiten Verbindungspartners 10.2 eingedrückt sind. Die Kontakthügel bestehen aus einer auf eine Chipmetallisierung bzw. auf eine Chipmetallisierung zusätzlich einer Zinkatschicht chemisch abgeschiedenen Nickelschicht der Dicke von im Beispiel 15 µm und einer darauf chemisch abgeschiedenen Goldschicht der Dicke von 5 µm. Die Nickelschicht baut einerseits eine je nach konkreter Kontaktierungsabsicht erforderliche Höhe des Kontakthügels auf und andererseits verhindert sie beim nachfolgenden Fügen aufgrund der geringeren Duktilität das vollständige Einsinken des Verbindungselementes 1 gegenüber einer dicken Schicht aus Gold. Des Weiteren verteilt die Nickelschicht die beim Fügen eventuell punktartig durch die Materialverdrängung der Verbindungselemente 1 auftretenden Druckkräfte auf eine gesamte Fläche eines Kontakthügels. Für die sichere Verbindung der Verbindungsflächen 7.1, 7.2 genügt ein Verbindungselement 1.

Figur 7 zeigt im Querschnitt einen als Halbleiterchip ausgebildeten zweiten Verbindungspartner 10.2 nach einer flip chip-Kontaktierung auf zwei als Leiterbahnen aus weichem Kupfer der Dicke von 20 µm ausgebildete erste Verbindungspartner 10.1. Dazu ist der zweite Verbindungspartner 10.2 in einen Durchbruch 14 des Substrates 11 angeordnet. Die Leiterbahnen sind mit Isolierlack 13 beschichtet. Die Verbindungselemente 1 wurden in die als Kontakthügel ausgebildeten zweiten Verbindungsflächen 7.2 eingepresst, als sich der Halbleiterchip noch in einem Waferverband befand. Die Kontakthügel bestehen, wie in Figur 6 gezeigt, aus einer Nickel- und Goldbeschichtung. Zum Eindrücken der Verbindungselemente 1 in die ersten Verbindungsflächen 7.1 der als Leiterbahnen ausgebildeten ersten Verbindungspartner 10.1 wurde der Halbleiterchip durch ein Bestückungswerkzeug auf eine Temperatur größer 200°C aufgeheizt, so dass die Verbindungselemente 1 den Isolierlack 13 leicht durchdringen konnten und die auf ihre Schmelztemperatur erwärmte Backlackschicht 13.2 sich mit den Kontakthügeln und eventuell mit Flächen des Halbleiterchips verkleben kann.

Eine weitere Verklebung des Backlackes 13.2 mit Deckfolien 15 als auch mit dem Halbleiterchip fand bei einem nachfolgenden Laminieren des Substrates 11 mit den beidseitig aufgelegten Deckfolien 15 statt. Das Substrat 11 und die Deckfolien 15 bestehen im Beispiel aus Polycarbonat und wurden beim Laminieren kurzzeitig auf 190°C erwärmt. Der zweite Verbindungspartner 10.2, d. h. der Halbleiterchip, wurde eingebracht in den Durchbruch 14 im Substrat 11, der nur geringfügig größer ist als eine Flächenabmessung des Halbleiterchips 15. Dicken des Substrats 11 und der Deckfolien 15 einerseits und eine Dicke des Halbleiterchips, der Kontakthügel und Leiterbahnen andererseits wurden so gewählt, dass der Halbleiterchip und die Leiterbahnen während des Laminierens zusammen gedrückt werden. Das infolge der Erwärmung beim Laminieren geschrumpfte und verschobene Polycarbonat hält den Halbleiterchip und die Leiterbahnen unter Druckspannung.

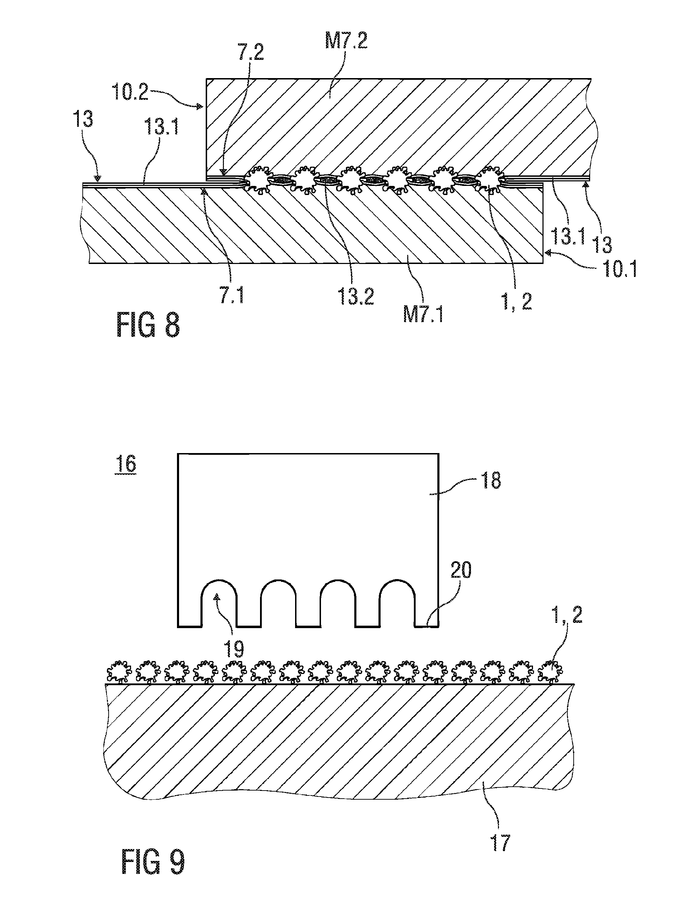

Figur 8 zeigt im Querschnitt zwei als Leiterbahnen aus duktilem Kupfer ausgebildete Verbindungspartner 10.1, 10.2, bei denen die Verbindungsflächen 7.1, 7.2 mit elektrisch isolierendem Isolierlack 13 oder mit einem anderem Schutzlack versehen sind, von denen aber mindestens eine äußere Lackschicht aufschmelzbar und mit den anderen Lackschichten verklebbar ist. Im Beispiel bestehen die Leiterbahnen aus 18 µm bis 50 µm dickem Kupfer und sind auf den Verbindungsflächen 7.1, 7.2 mit einer Kernlackschicht 13.1 und einer Backlackschicht 13.2 der Qualität V155 B180 Grad 1 beschichtet.

Die Verbindungselemente 1 haben ein Größtmaß von 15 µm und bestehen aus Edelstahl. Die Verbindungselemente 1 wurden auf der ersten Verbindungsfläche 7.1 des als untere Leiterbahn ausgebildeten ersten Verbindungspartner 10.1 abgesetzt, anschließend wurde der zweite Verbindungspartner 10.2, d. h. die obere Leiterbahn mit deren zweiter Verbindungsfläche 7.2 über der ersten Verbindungsfläche 7.1 der unteren Leiterbahn 18 positioniert und anschließend sind die Verbindungspartner 10.1, 10.2 unter Zusammendrücken bei 200°C kontaktiert worden. Der kurzzeitig geschmolzene Backlack 13.2 verteilt sich zwischen den Verbindungsflächen 7.1, 7.2 und um die Verbindungselemente 1 herum und verklebt nach Erstarren zusätzlich die Verbindungsflächen 7.1, 7.2.

Figur 9 zeigt in der Seitenansicht eine Vorrichtung 16 zum Aufbringen von Verbindungselementen 1. Diese umfasst einen flächenhaften Verbindungselementespeicher 17, welcher als Speicherplatte ausgebildet ist, auf welcher einlagig Verbindungselemente 1 deponiert sind. Über der Speicherplatte ist ein Aufbringwerkzeug 18 dargestellt, welches zeitweise magnetisierbar ist. Eine rasterartige Wirkfläche 19 besteht aus hartem, magnetisch leitendem Werkzeugstahl. Jede einzelne Rasterfläche 20 weist eine Größe von 20 x 20 µm² auf und Abstände zwischen den Rasterflächen 20 betragen in beiden Richtungen jeweils 40 µm. Im Beispiel bilden die Rasterflächen 20 ein Raster von 5 x 5 einzelnen Rasterflächen 20. Mit dem Aufbringwerkzeug 18 werden von dem Verbindungselementespeicher 17 magnetische Verbindungselemente 1 aufgenommen, wobei jede Rasterfläche 20 ein Verbindungselement 1 aufnimmt, der Verbindungsfläche 7.1, 7.2 des Verbindungspartners 10.1, 10.2 zuführt und dort eingedrückt. Da nur wenige Verbindungselemente 1 für die mechanische und elektrische Verbindung notwendig sind, ist es sinnvoll, nur wenige Verbindungselemente 1 in die Verbindungsfläche 7.1, 7.2 einzudrücken.

Im Querschnitt zeigt Figur 10 einen als Verbindungsstück aus Kupfer ausgeformten dritten Verbindungspartner 10.3 zu einer mittelbaren Verbindung der als Leiterbahnen ausgeformten ersten und zweiten Verbindungspartner 10.1, 10.2. Das Verbindungsstück ist im Durchbruch 14 des im Beispiel thermoplastischen Substrates 11 angeordnet. Beidseitig des Substrates 11 sind die Leiterbahnen aus Kupfer der Dicke von 25 µm angeordnet. Nach Anordnen des erstem Verbindungspartners 10.1, d. h. der unteren Leiterbahn, wurden in deren Verbindungsfläche 7.1 mit Spikes 6 versehene Verbindungselemente 1 aus Werkzeugstahl eingebracht, anschließend der als Verbindungsstück ausgeformte dritte Verbindungspartner 10.2 in den Durchbruch 14 eingebracht und mit einer unteren dritten Verbindungsfläche 7.3 in die Verbindungselemente 1 eingedrückt, danach Verbindungselemente 1 auf eine nach oben weisende dritte Verbindungsfläche 7.3 des Verbindungsstückes eingedrückt und schließlich als zweiten Verbindungspartner 10.2 die obere Leiterbahn als zweiter Verbindungspartner 10.2 über dem Durchbruch 14 bzw. dem als Verbindungsstück ausgebildeten dritten Verbindungspartner 10.3 angeordnet und die zweite Verbindungsfläche 7.2 gegen das Verbindungsstück gedrückt. Damit wurde eine sichere Durchkontaktierung ohne Wärmeprozesse und ohne elektrisch leitende Kleber erzielt.

In Figur 11 sind zwei domartige, auf einer als Kontakthügel eines Halbleiterchips ausgebildeten ersten Verbindungsfläche 7.1 aufgesinterte Verbindungselemente 1 im Querschnitt dargestellt. Der Kontakthügel besteht aus einer 25 µm dicken Nickelschicht. Die etwa 80 µm langen Verbindungselemente 1 bestehen ebenfalls aus Nickel. Die Verbindungselemente 1 weisen an einer Basis 26 einen Durchmesser von etwa 35 µm auf und sind an einer Spitze 21 etwa 10 µm dick. Bedingt durch den laserbewirkten Sinterprozess und dazu verwendete Partikel eines Metallpulvers sind die Verbindungselemente 1 über ihre gesamte Oberfläche 2 rau. In einem Längenabschnitt 22 etwa in der Mitte der Länge der Verbindungselemente 1 besteht das aufgesinterte Material aus Kupfer. Dieses duktile Material bewirkt zusammen mit einer gezielten Schrägstellung der Verbindungselemente 1, dass nach Eindrücken der Verbindungselemente 1 in dünne gewebeartige Materialien oder elektrisch leitfähige Fasermaterialien als zweite Verbindungspartner 10.2 die Spitzen 21 einfach abgebogen werden können und dadurch der Halbleiterchip noch besser mit dem Gewebe verbunden ist.

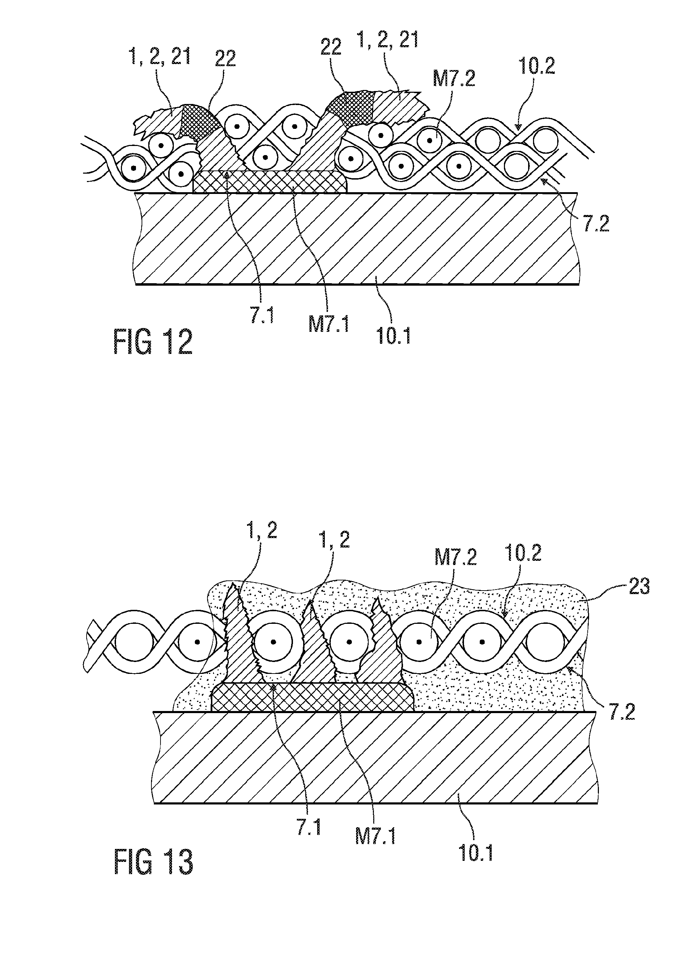

Eine Verhakung der abgebogenen Spitzen 21 der Verbindungselemente 1 mit dem Gewebe des zweiten Verbindungspartners 10.2 ist im Querschnitt in Figur 12 gezeigt. Die Verformung der Verbindungselemente 1 fand in den Längenabschnitten 22 der Verbindungselemente 1 mit dem duktilen Material statt. Die Spitzen 21 drücken Teile des Gewebes in Richtung des ersten Verbindungspartners 10.1, d. h. des Halbleiterchips. Durch die gegeneinander stehende Schrägstellung der Verbindungselemente 1 wird das Gewebe des zweiten Verbindungspartners 10.2 geklammert. Die Verbindungselemente 1 drücken auf elektrisch leitfähige Fasern des Gewebes des zweiten Verbindungspartners 10.2.

Ebenfalls eine elektrische Verbindung eines Halbleiterchips mit elektrisch leitfähigen Fasern eines Gewebes ist im Querschnitt in Figur 13 dargestellt. Die auf einer Nickelschicht einer als Kontakthügel ausgebildeten ersten Verbindungsfläche 7.1 aufgesinterten nadelförmigen Verbindungselemente 1 aus Nickel weisen gegenüber den Verbindungselementen 1 in Figur 12 eine kleinere Länge und einen etwas kleineren Durchmesser auf und sie sind senkrecht auf der ersten Verbindungsfläche 7.1 angeordnet. Ein permanenter Verbund von elektrisch leitenden Fasern des Gewebes des zweiten Verbindungspartners 10.2 mit den Verbindungselementen 1 wird durch einen Sicherungskleber 23 unterstützt, der nachträglich auf das Gewebe über dem Hableiterchip aufgebracht und anschließend ausgehärtet wurde. Der beim Härten vorübergehend niederviskos werdende Sicherungskleber 23 penetrierte das Gewebe des zweiten Verbindungspartners 10.2 und verband dieses mit der Oberfläche des ersten Verbindungspartners 10.1, d. h. des Halbleiterchips.

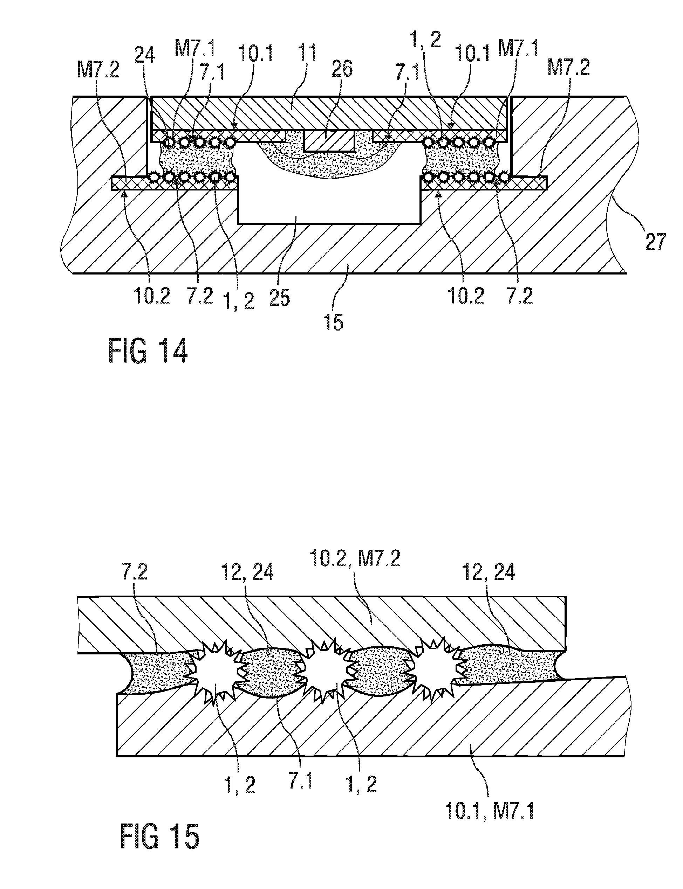

Die Anwendung von Verbindungselementen 1 zur ausschließlichen Sicherung der Verbindung von Verbindungsflächen 7.1, 7.2 von Verbindungspartnern 10.1, 10.2 mit elektrisch leitendem Kleber 24 ist im Querschnitt in Figur 14 gezeigt. Für die Verbindung von als erste Verbindungspartner 10.1 ausgeformten Leiterbahnen eines kleinflächigen Substrates 11, in dessen Flächenmitte ein Bauteil 26, beispielsweise ein Halbleiterchip aufgeklebt ist, welcher mit den Leiterbahnen, die auf dem kleinflächigen Substrat 11 befindlich sind, elektrisch verbunden ist, mit Leiterbahnen aus Kupfer ausgeformten zweiten Verbindungspartnern 10.2, die sich in einer Ausnehmung 25 eines Laminates 27 befinden, ist elektrisch leitender Kleber 24 verwendet worden.

Aufgrund zu erwartender Scherbewegungen zwischen den Verbindungsflächen 7.1, 7.2 der als Leiterbahnen ausgeformten Verbindungspartner 10.1, 10.2 ist der nach Erstarren bzw. Aushärten elastischer bzw. bedingt plastischer, elektrisch leitender Kleber 24, im Beispiel ein thermoplastischer Silberleitkleber, eingesetzt worden. Die Scherbewegungen sollen durch eine relativ dicke Kleberfuge aufgenommen werden, ohne dass es zu einem Bruch des elektrisch leitenden Klebers 24 in sich oder zu einem Abriss des elektrisch leitenden Klebers 24 von den Verbindungsflächen 7.1, 7.2 der Verbindungspartner 10.1, 10.2, d. h. der Leiterbahnen kommt. Zur Verhinderung des Abrisses des elektrisch leitenden Klebers 24 von den Verbindungsflächen 7.1, 7.2 sind in die Verbindungsflächen 7.1, 7.2 der Verbindungspartner 10.1, 10.2 Verbindungselemente 1 mit einem Größtmaß bis zu 30 µm vor dem Verkleben eingedrückt worden. Dadurch wird selbst bei extremen mechanischen Belastungen die Verbindung gesichert.

Figur 15 zeigt im Querschnitt die Verbindung zweier als Leiterbahnen aus Kupfer ausgeformter Verbindungspartner 10.1, 10.2 mit kristallitrauen nahezu kugelförmigen Verbindungselementen 1 eines mittleren Durchmessers von 20 µm. Die Verbindungselemente 1 sind nur gering in die Materialien M7.1, M7.2 der Verbindungsflächen 7.1, 7.2 eingedrückt und vollziehen die elektrische Verbindung. Mittels des ausgehärteten, im Spalt zwischen den Verbindungsflächen 7.1, 7.2 der als Leiterbahnen ausgeformten Verbindungspartner 10.1, 10.2 befindlichen Klebers 12 oder gegebenenfalls elektrisch leitenden Klebers 24, wird die mechanische Verbindung gesichert.

### BEZUGSZEICHENLISTE

- 1: Verbindungselement
- 2: Oberfläche des Verbindungselements
- 3: Poren
- 4: Hinterschneidungen
- 5: Spratzer
- 6: Spikes
- 7.1, 7.2, 7.3: Verbindungsflächen
- M7.1, M7.2, M7.3: Material der Verbindungsflächen
- 8: Kavitäten
- 9: Aufkerbungen
- 10.1, 10.2, 10.3: Verbindungspartner
- 11: Substrat
- 12: Kleber
- 13: Isolierlack
- 13.1: Kernlackschicht
- 13.2: Backlackschicht
- 14: Durchbruch
- 15: Deckfolie
- 16: Vorrichtung zum Aufbringen von Verbindungselementen
- 17: Verbindungselementespeicher
- 18: Aufbringwerkzeug
- 19: rasterartige Wirkfläche
- 20: Rasterfläche
- 21: Spitze eines Verbindungselementes
- 22: Längenabschnitt eines Verbindungselementes
- 23: Sicherungskleber
- 24: elektrisch leitender Kleber
- 25: Ausnehmung
- 26: Bauteil
- 27: Laminat

## Patentansprüche

1. Schaltungsanordnung, umfassend zumindest zwei Verbindungspartner (10.1, 10.2, 10.3), welche über Verbindungsflächen (7.1, 7.2, 7.3) elektrisch und/oder mechanisch miteinander verbunden sind, wobei die Verbindungspartner (10.1, 10.2, 10.3) Leiterbahnen, elektrisch leitfähige Fasermaterialien und/oder elektronische Bauelemente sind,
**dadurch gekennzeichnet, dass** zwischen den Verbindungsflächen (7.1, 7.2, 7.3) zumindest ein Verbindungselement (1) angeordnet ist, welches Hinterschneidungen aufweist und mit einer der Verbindungsflächen (7.1, 7.2, 7.3) formschlüssig und/oder stoffschlüssig elektrisch und mechanisch verbunden ist und mit der jeweils anderen Verbindungsfläche (7.1, 7.2, 7.3) formschlüssig elektrisch und mechanisch verbunden ist.

2. Schaltungsanordnung nach Anspruch 1,
**dadurch gekennzeichnet, dass** das Verbindungselement (1) in ein Material (M7.1, M7.2, M7.3) zumindest einer Verbindungsfläche (7.1, 7.2, 7.3) teilweise eingepresst ist.

3. Schaltungsanordnung nach Anspruch 1 oder 2,
**dadurch gekennzeichnet, dass** das Verbindungselement (1) kugelförmig, quaderähnlich, vieleckig, elliptisch, länglich, pyramidenförmig oder spitzkegelig ausgeformt ist.

4. Schaltungsanordnung nach Anspruch 3,
**dadurch gekennzeichnet, dass** das länglich, pyramidenförmig oder spitzkegelig ausgeformte Verbindungselement (1) zumindest abschnittsweise aus einem duktilen Material ist.

5. Schaltungsanordnung nach einem der vorhergehenden Ansprüche,
**dadurch gekennzeichnet, dass** auf einer Oberfläche (2) des Verbindungselementes (1) Poren (3), Kanten, Spratzer (5), Spikes (6), Kavitäten (8) und/oder Knospen ausgebildet sind und/oder eine aufgeraute Oberflächenstruktur ausgebildet ist.

6. Schaltungsanordnung nach einem der vorhergehenden Ansprüche,
**dadurch gekennzeichnet, dass** das Verbindungselement (1) aus einem metallisierten keramischen Material hoher Festigkeit und Härte ist.

7. Schaltungsanordnung nach einem der vorhergehenden Ansprüche,
**dadurch gekennzeichnet, dass** das Verbindungselement (1) mit einer bis zu 0,5 µm dicken duktilen Edelmetallschicht, insbesondere Silber, überzogen ist.

8. Schaltungsanordnung nach einem der vorhergehenden Ansprüche,
**dadurch gekennzeichnet, dass** zwischen den Verbindungsflächen (7.1, 7.2, 7.3) eine Mehrzahl gleichartiger oder unterschiedlich ausgeformter und/oder aus unterschiedlichem Material gebildeter Verbindungselemente (1) angeordnet sind.

9. Schaltungsanordnung nach Anspruch 8,
**dadurch gekennzeichnet, dass** die Verbindungselemente (1) netzartig oder ringförmig angeordnet und miteinander verbunden sind.

10. Verfahren zum elektrischen und mechanischen Verbinden von Verbindungspartnern (10.1, 10.2, 10.3) einer Schaltungsanordnung, wobei die Verbindungspartner (10.1, 10.2, 10.3) Leiterbahnen, elektrisch leitfähige Fasermaterialien und/oder elektronische Bauelemente sind,
**dadurch gekennzeichnet, dass** in einem ersten Schritt auf zumindest einer Verbindungsfläche (7.1, 7.2, 7.3) zumindest eines
Verbindungspartners (10.1, 10.2, 10.3) zumindest ein Verbindungselement (1), welches Hinterschneidungen aufweist, angeordnet wird und/oder durch eine Bearbeitung zumindest einer Verbindungsfläche (7.1, 7.2, 7.3) zumindest eines Verbindungspartners (10.1, 10.2, 10.3) stoffschlüssig elektrisch und mechanisch verbunden erzeugt wird und in einem zweiten Schritt die Verbindungsflächen (7.1, 7.2, 7.3) der Verbindungspartner (10.1, 10.2, 10.3) übereinander positioniert und unter Druckbeaufschlagung miteinander elektrisch und mechanisch verbunden werden, wobei das zumindest eine Verbindungselement (1) mit zumindest einer der Verbindungsflächen (7.1, 7.2, 7.3) formschlüssig elektrisch und mechanisch verbunden wird.

11. Verfahren nach Anspruch 10,
**dadurch gekennzeichnet, dass** das Verbindungselement (1) durch galvanische und/oder chemische Abscheidungen auf die Verbindungsfläche (7.1, 7.2, 7.3) und/oder durch laserbewirktes Sintern und/oder durch ein Aufschmelzen auf die Verbindungsfläche (7.1, 7.2, 7.3) erzeugt wird.

12. Verfahren nach einem der Ansprüche 10 oder 11,
**dadurch gekennzeichnet, dass** vor dem Verbinden zweier Verbindungsflächen (7.1, 7.2, 7.3) das Verbindungselement (1) auf der Verbindungsfläche (7.1, 7.2, 7.3) angeordnet wird, welches eine geringere Duktilität und/oder eine höhere Härte aufweist und teilweise in diese Verbindungsfläche (7.1, 7.2, 7.3) eingepresst wird.

13. Verfahren nach Anspruch 12,
**dadurch gekennzeichnet, dass** zum Einpressen des Verbindungselementes (1) ein Material (M7.1, M7.2, M7.3) der Verbindungsfläche (7.1, 7.2, 7.3) durch thermische Energie oder mittels Ultraschall erwärmt wird.

14. Verfahren nach einem der Ansprüche 10 bis 13,
**dadurch gekennzeichnet, dass** das Verbindungselement (1) nach dem Verbinden verformt wird.

15. Vorrichtung (16) zum Aufbringen von Verbindungselementen (1) auf eine Verbindungsfläche (7.1, 7.2, 7.3), umfassend ein Aufbringwerkzeug (18) und einen Verbindungselementespeicher (17),
**dadurch gekennzeichnet, dass** die Verbindungselemente (1) mittels des Aufbringwerkzeugs aus dem flächenhaften Verbindungselementespeicher (17) aufnehmbar und in die Verbindungsfläche (7.1, 7.2, 7.3) eindrückbar sind, wobei das Aufbringwerkzeug (18) zeitweise magnetisierbar ist und eine rasterartige Wirkfläche aufweist.
